**Europäisches Patentamt**

**European Patent Office**

**Office européen des brevets**

(19)

(11) Veröffentlichungsnummer : **0 052 847**
**B1**

(12) **EUROPÄISCHE PATENTSCHRIFT**

(45) Veröffentlichungstag der Patentschrift :
17.07.85

(21) Anmeldenummer : 81109704.7

(22) Anmeldetag : 16.11.81

(51) Int. Cl.⁴ : **H 03 H 17/06**

(54) Verfahren und Schaltungsanordnung zur Umsetzung der Abtastfrequenz einer Abtastfolge unter Umgehung der Konversion in ein kontinuierliches Signal.

(30) Priorität : 26.11.80 CH 8754/80

(43) Veröffentlichungstag der Anmeldung :
02.06.82 Patentblatt 82/22

(45) Bekanntmachung des Hinweises auf die Patenterteilung : 17.07.85 Patentblatt 85/29

(84) Benannte Vertragsstaaten :
AT BE CH DE FR GB IT LI LU NL SE

(56) Entgegenhaltungen :
IEEE TRANSACTIONS ON COMMUNICATIONS, Band com-28, Nr. 2, Februar 1980, Seiten 244-249, New York, USA K.M.Wong et al.: " Commutativity and application of digital interpolation filters and modulators ".
PROCEEDINGS OF THE IEEE, Band 61, Nr. 6, Juni 1973, Seiten 692-702, New York, USA R.W. SCHAFER et al.: " A digital signal processing approach to interpolation "

(73) Patentinhaber : Willi Studer AG, Fabrik für elektronische Apparate
Althardstrasse 30
CH-8105 Regensdorf (CH)

(72) Erfinder : Lagadec, Roger
Klusdörfli 6
CH-8032 Zürich (CH)
Erfinder : Kunz, Henry O.
Hinteres Rumstal
CH-8422 Pfungen (CH)

(74) Vertreter : EGLI-EUROPEAN PATENT ATTORNEYS
Horneggstrasse 4
CH-8008 Zürich (CH)

**0 052 847**

**Beschreibung**

Die Erfindung liegt auf dem Gebiet der Signalverarbeitung und bezieht sich auf ein Verfahren zur Umsetzung einer Eingangsabtastfolge mit einer Eingangsabtastfrequenz in eine Ausgangsabtastfolge mit einer wählbaren Ausgangsabtastfrequenz mit Hilfe eines Abtastfilters derart, dass die beiden Abtastfolgen Frequenzspektren aufweisen, die in einem Frequenzbereich amplitudenmässig identisch sind, der sich von der Frequenz Null bis zur Hälfte der niedrigeren der beiden Abtastfrequenzen erstreckt, bis auf einen Fehleranteil, der nur durch die Genauigkeit der Verarbeitung der Abtastwerte begrenzt wird ; sowie auf eine Schaltungsanordnung zur Durchführung des Verfahrens.

Bis heute kennt man zwei grundsätzlich verschiedene Vorgehen zur Umsetzung der Abtastfrequenz eines abgetasteten Signals.

Das erste Vorgehen besteht in der Umwandlung des abgetasteten quantisierten Signals in ein kontinuierliches Signal. Ein analoges Tiefpassfilter unterdrückt dabei die hochfrequenten Anteile des Eingangssignals. Das durch die Umwandlung herbeigeführte kontinuierliche Signal wird anschliessend mit der gewünschten ausgangsseitigen Abtastfrequenz wieder neu abgetastet. Eine notfalls zur Vermeidung von Rückfaltungsfrequenzen (« Aliasing ») erforderliche Bandbegrenzung erreicht man durch entsprechende Dimensionierung des Tiefpassfilters. Arbeitet man mit abgetasteten Signalen digitaler Form, so verlangt dieses Verfahren den Einsatz eines Digital-Analog-Wandlers und eines Analog-Digital-Wandlers, was mit erheblichem Aufwand verbunden ist.

Dieses Vorgehen zur Umsetzung der Abtastfrequenz ist zur Zeit nirgends in der Literatur explizit beschrieben, kann aber durchaus dem heutigen Stand der Technik zugeordnet werden.

Bei abgetasteten Signalen bietet sich auch ein grundsätzlich anderes zweites Vorgehen zur Umsetzung der Abtastrate an, dies jedoch nur unter der Voraussetzung eines festen Verhältnisses zwischen der Eingangs- und der Ausgangsabtastfrequenz. Lässt sich das Verhältnis der zwei Abtastfrequenzen als das Verhältnis zweier ganzer Zahlen darstellen, so haben auch die zwei Abtastfrequenzen gemeinsame ganzzahlige Vielfachfrequenzen. Die Umsetzung der Abtastfrequenz geschieht dann durch Erhöhung der Eingangsabtastfrequenz auf eine der gemeinsamen ganzzahligen Vielfachfrequenzen und durch anschliessende Herabsetzung auf die Ausgangsabtastfrequenz, beidesmal in einem ganzzahligen Verhältnis. Zur Erhöhung der Abtastfrequenz um einen Faktor N, werden zuerst zwischen jeweils zwei zeitlich nacheinanderfolgenden Abtastwerten der Eingangsabtastfolge je $(N - 1)$ äquidistante, nullwertige Abtastwerte eingeführt. Das resultierende Signal hat das gleiche Spektrum wie das ursprüngliche Signal, jedoch eine entsprechend erhöhte Abtastfrequenz.

Zur Weiterverarbeitung des Signals müssen noch die höheren Teilspektren zwischen der Hälfte der ursprünglichen Abtastfrequenz und der Hälfte der neuen, höheren Abtastfrequenz unterdrückt werden, was mit einem Abtastfilter mit Tiefpasscharakter geschieht. Durch Unterabtastung der neuen Abtastfolge mit der Ausgangsabtastfrequenz wird das Spektrum gefaltet. Eine notfalls zur Vermeidung von Faltungsfrequenzen erforderliche Bandbegrenzung kann auch hier realisiert werden, indem das Abtastfilter mit Tiefpasscharakter entsprechend dimensioniert wird.

Verwendet man zudem für die Tiefpassfilterung transversale Filter, so kann ein beträchtlicher Teil des Verarbeitungsaufwands vermieden werden, indem diejenigen Multiplikationen von Signalvariablen mit Filterkoeffizienten, bei welchen die Variablen nullwertig sind, nicht ausgeführt werden, und auch die Zwischenwerte der Abtastfolge mit hoher Abtastfrequenz, die wegen der Unterabtastung nicht benötigt werden, gar nicht erst ermittelt werden.

Die Abtastfrequenz am Eingang und am Ausgang bestimmen die kleinste mögliche, ganzzahlige Vielfachfrequenz sowie die Koeffizienten des Abtastfilters, welches damit bei jedem neuen Verhältnis der zwei Abtastfrequenzen neu dimensioniert werden muss. Diese Art Umsetzung der Abtastfrequenz findet man beispielsweise in Schaefer & Rabiner, A Digital Signal Processing Approach to Interpolation, Proc. IEEE, 61-6, June 1973 beschrieben.

Ein Nachteil dieses zuletzt beschriebenen Vorgehens ist, dass bei nicht einfachen Verhältnissen der Abtastfrequenz die kleinste gemeinsame ganzzahlige Vielfachfrequenz sehr hoch liegen wird. Es resultiert daraus eine entsprechend hohe Filterordnung, da die relative Steilheit des Amplitudengangs des Abtastfilters mit Tiefpasscharakter dadurch auch zunimmt.

Eine Erhöhung bzw. Herabsetzung der Abtastfrequenz kann auch mehrstufig geschehen. Von Vorteil ist dabei, dass die einzelnen Filterordnungen niedriger gestaltet werden können.

Aus IEEE Transactions on Communications Band com-28, Nr. 2, Februar 1980, Seiten 244-249, ist ein Verfahren zum Filtern und sinusförmigen Modulieren eines Signales bekannt. Dabei wird die Filterung und die Modulierung digital durchgeführt. Die Filterung erfolgt dabei in einem Interpolationsfilter, der zudem mit einem Sinusmodulator in Serie geschaltet ist. Dieses Interpolationsfilter kann dabei ersetzt werden durch ein Halteglied, welches durch ein Zeitvariantenfilter mit periodisch variierenden Koeffizienten ergänzt ist. Dabei kann das Zeitvariantenfilter in der Serieschaltung mit dem Halteglied und dem Sinusmodulator vertauscht werden, wenn dessen Abtastfrequenz ein ganzzahliges Vielfaches der ursprünglichen Abtastfrequenz ist. Beträgt die Abtastfrequenz kein ganzzahliges Vielfaches, so müssen die Koeffizienten des Zeitvariantenfilters verändert werden.

Dieses Verfahren eignet sich nur für bekannte ganzzahlige oder andere Verhältnisse und seine

2

Anwendung bei beliebig variierenden Verhältnissen erfordert deshalb eine ständige Berechnung des momentan benötigten Satzes von Koeffizienten des gesamten Filters.

Es ist die Aufgabe der Erfindung, ein Verfahren zur Umsetzung der Abtastfrequenz zu schaffen, das einerseits die Flexibilität in der Anwendung aufweist, die durch das Vorgehen der Rückführung in ein kontinuierliches Signal und Wiederabtastung gegeben ist, ohne dessen Nachteile aufzuweisen, die durch die Umwandlung von abgetasteten in kontinuierliche Signale und umgekehrt gegeben sind.

Es ist weiter Aufgabe der Erfindung, ein Verfahren zu schaffen, bei welchem ein einziger Satz von Filtern die Umsetzung der Abtastfrequenz für einen weiten Bereich von Anwendungen ermöglicht, und somit eine Neuberechnung oder Umschaltung von Filtern in Funktion der verwendeten Ein- und Ausgangsabtastraten vermeidet.

Es ist ferner Aufgabe der Erfindung, ein Verfahren zu schaffen, gemäss welchem mit denselben schaltungstechnischem Aufwand ein Eingangssignal mit einer gegebenen Abtastfrequenz in ein Ausgangssignal mit einer beliebigen Abtastfrequenz umgesetzt wird, wobei die beiden Signale bis zu einer Frequenz, die der Hälfte der niedrigeren der beiden Abtastfrequenzen entspricht, den gleichen spektralen Inhalt haben.

Es ist weiter Aufgabe der Erfindung, eine Schaltungsanordnung anzugeben, mit der das Verfahren zur Umsetzung der Abtastfrequenz durchgeführt werden kann.

Eine weitere Aufgabe der Erfindung ist es, die Schaltungsanordnung derart anzugeben, dass zur Realisierung der Schaltung im einzelnen, die Vielfalt der bestehenden integrierten Schaltungsbausteine mitberücksichtigt und optimal ausgenützt wird.

Diese Aufgaben werden durch die in den kennzeichnenden Teilen der unabhängigen Patentansprüche angegebenen Erfindung für ein Verfahren und eine Schaltungsanordnung gelöst.

Zur eingehenden Erklärung der Erfindung werden die folgenden Figuren mitverwendet.

Figur 1 zeigt eine erfindungsgemässe Schaltungsanordnung als Blockschaltbild, wie sie zur Durchführung des Verfahrens verwendet wird.

Figur 2 zeigt eine Teilschaltung gemäss Fig. 1 zur Messung der Zeitdifferenz zwischen Eingangsabtastzeitpunkt und von aussen vorgegebenem Ausgangsabtastzeitpunkt.

Figur 3 zeigt eine Teilschaltung gemäss Fig. 1 zur Messung der Zeitdifferenz zwischen Eingangsabtastzeitpunkt und intern umgerechnetem Ausgangsabtastzeitpunkt.

Figur 4 zeigt eine weitere Teilschaltung gemäss Fig. 1, zur Messung der Zeitdifferenz, ergänzt durch eine Vorrichtung zur zeitlichen Mittelung.

Figur 5 zeigt dás erweiterte Schaltungsbild des Abtastfilters gemäss Fig. 1, mit Unterabtastung am Ausgang.

Figur 6 zeigt ein anderes erweitertes Schaltungsbild des Abtastfilters gemäss Fig. 1, mit Einschieben von nullwertigen Abtastwerten zu Erhöhung der Abtastfrequenz am Eingang.

Figur 7 zeigt eine Schaltungsanordnung, durch welche das Abtastfilter je nach Abtastfrequenzverhältnis in seiner Konfiguration umgeschaltet wird.

Figur 8 zeigt eine modifizierte Schaltungsanordnung gemäss Fig. 1, unter Verwendung eines Vorfilters.

Figur 9 zeigt eine weitere Modifikation der Schaltungsanordnung gemäss Fig. 1, unter Verwendung eines Nachfilters.

Figur 10 zeigt die Möglichkeit der Kombination der nach Fig. 8 und 9 modifizierten Schaltung zu einer Schaltung zur Durchführung des Verfahrens und

Figur 11 zeigt schematisch die Verarbeitungsschritte bei der Umsetzung.

Vor dem Eingehen auf die einzelnen Details, soll im voraus in kommentierender Weise ein orientierender Ueberblick gegeben werden.

Nach dem hier vorgeschlagenen Verfahren betrachtet man einmal die Eingangsabtastfolge, dann eine Umsetzungsabtastfolge mit einer sehr hohen Umsetzungsabtastfrequenz und schliesslich die Ausgangsabtastfolge.

Falls das Ausgangsabtastsignal zu Zeitpunkten definiert ist, die nicht zum Raster des Umsetzungsabtastsignals passen, so ist es doch möglich, das Umsetzungssignal zu verwenden, indem auf der Zeitachse Nachbarpunkte an Stelle der fehlenden Punkte verwendet werden, jedoch auf Kosten einer Verjitterung des Abtastzeitpunktes, oder, damit verbunden, einer Verjitterung der Ausgangsabtastfolge.

Je höher die Umsetzungsabtastrate, desto niedriger wird dieser Abtastjitterfehler.

Wie hoch die Umsetzungsabtastrate für einen gegebenen Jitterfehler gewählt werden muss, lässt sich berechnen. Auf Grund dieser Umsetzungsabtastfrequenz ergibt sich auch ein entsprechendes Abtastfilter zur Erhöhung bzw. Herabsetzung der Abtastfrequenz.

Der Frequenzgang dieses Filters zur Umsetzung der Abtastrate lässt sich berechnen, sowie damit das entsprechende Spektrum nach der Verarbeitung mit dem Filter.

Unter der Voraussetzung der Verwendung transversaler Filter wird jeder Punkt der Umsetzungsabtastfolge berechnet als Skalarprodukt des Koeffizientenvektors des Filters mit dem momentan benötigten Vektor der Eingangsvariablen. Bei Verwendung eines Abtastfilters zur Erhöhung der Abtastrate sind viele Komponenten dieses Vektors nullwertig.

Bei jeder Berechnung eines Ausgangspunktes muss ein solches Skalarprodukt berechnet werden. Die genaue Lage des Ausgangsabtastpunktes bestimmt die Lage des zu berechnenden Punktes im Raster der Umsetzungsabtastfolge, und damit auch diejenigen Koeffizienten, die nicht nullwertigen Komponenten des Eingangsvariablen-Vektors zugeordnet sind. Man kann auch sagen, dass die Bestimmung der Lage des Ausgangsabtastpunktes mit der Genauigkeit des Rasters der Umsetzungsabtastfolge den zu berechnenden Punkt, die dazu benötigten nicht nullwertigen Eingangsabtastwerte und die zugehörigen Koeffizienten des Filters exakt definiert.

Die relative Lage des Ausgangsabtastpunktes bezüglich der Eingangsabtastpunkte ist somit die Schlüsselinformation zur Steuerung der Verarbeitung, bei Erhöhung der Abtastfrequenz. Eine gleichwertige Information ist in der relativen Lage des Eingangsabtastpunktes bezüglich der Ausgangsabtastpunkte bei Herabsetzung der Abtastfrequenz.

Natürlich ist der Zusammenhang zwischen der relativen Lage der Abtastpunkte einerseits und den Filterkoeffizienten andererseits einfacher, wenn die Filterlängen und das Verhältnis bei der Erhöhung oder Herabsetzung der Abtastfrequenz in einer einfachen Beziehung zueinander stehen.

Selbstverständlich ist es möglich, durch mehrstufige Gestaltung des Filters seine Realisierung drastisch zu erleichtern.

Beispielsweise kann die Abtastrate sukzessive erhöht werden, dies mit Hilfe von Abtastfiltern, bis die sehr hohe Umsetzungsabtastrate erreicht wird.

Ein weiterer Weg besteht darin, das Signal mit der Umsetzungsabtastrate zu erzeugen, und die Abtastfrequenz sukzessive durch Filterung herabzusetzen.

Die beiden geschilderten Vorgehen sind prinzipiell symmetrisch. In beiden Fällen arbeitet man mit einer relativen zeitlichen Differenz der Abtastzeitpunkte.

Arbeitet man mit beliebigen Verhältnissen der Abtastfrequenzen, so kann es vorkommen, dass die Bandbegrenzung der Signale nicht ausreicht. In diesem Fall ist es günstig, vor der Umsetzung der Abtastrate eine entsprechende Bandbegrenzung vorzunehmen, bzw. sie nach Umsetzung der Abtastfrequenz vorzunehmen. In diesem Fall wird das Verfahren erweitert durch eine zusätzliche Vor- und Nachfilterung.

Die Erhöhung der Abtastrate mit Hilfe eines Abtastfilters geschieht bekanntlich, indem zuerst nullwertige Abtastwerte zwischen den ursprünglichen Abtastwerten eingeschoben werden, und indem die dadurch entstandene neue Abtastfolge mit einem Filter bei der höheren Abtastrate verarbeitet wird. Bei einer mehrstufigen Erhöhung der Abtastrate wird dieser Vorgang mehrmals wiederholt. Die Einschiebung nullwertiger Abtastwerte ist streng periodisch, und die Multiplikation einer nullwertigen Variable mit einem Koeffizient als Teil der Berechnung eines Filterausgangswertes (im Sinne der vorhin erwähnten Skalarprodukte) können fallengelassen werden. Dies gilt sowohl bei ein- als auch bei mehrstufigen Filtern.

Eine weitere Vereinfachung, insbesondere der Steuerung und Umrechnung, erreicht man, indem Zweierpotenzen für die Faktoren zur Erhöhung bzw. Herabsetzung der Abtastfrequenzen, sowie für die Filterlängen gewählt werden.

Der Ersatz eines Punktes einer kontinuierlichen Funktion durch den nächstgelegenen Punkt eines periodischen Rasters entspricht der Verarbeitung des kontinuierlichen Signals durch ein Abtast- und Halteglied. Das gleiche gilt vom Ersatz eines Punktes einer abgetasteten Funktion durch den nächstgelegenen Punkt eines periodischen Rasters, das einer Unterabtastung entspricht.

In diesem Fall muss das Abtast- und Halteglied im Sinne eines abgetasteten und nicht mehr eines kontinuierlichen Systems verstanden werden. Die Uebertragungsfunktion des kontinuierlichen sowie des zeitdiskreten Abtast- und Haltegliedes ist bekannt. Im kontinuierlichen Fall z. B. lautet die Uebertragungsfunktion im Laplace-Bereich:

$$H(p) = 1 - \exp(-pT)/p \quad (p : \text{Laplace-Operator}, \ T : \text{Abtastperiode})$$

Bei diskretem Abtast- und Halteglied, verbunden mit einer Herabsetzung der Abtastrate um einen Faktor n, lautet die entsprechende Formel im z-Bereich:

$$H(z) = 1 - z^n/1 - z$$

Trifft man Annahmen für die spektrale Verteilung des Eingangssignals, sowie über die bereits geschehene Erhöhung der Abtastrate, so liefern die zwei vorstehenden Formeln ein Mass für den zu erwartenden Fehler bei einer gegebenen Umsetzungsabtastrate.

Der Amplitudengang dieser Uebertragungsfunktionen im Frequenzbereich ist für das Verständnis des Vorganges besonders interessant. Es zeigt sich, dass diese Uebertragungsfunktionen des erste Teilspektrum der abgetasteten Signale durchlassen, die höher gelegenen Teilspektren hingegen bis zu einem gewissen Mass unterdrücken. Verwendet man an Stelle von Abtasthaltegliedern herkömmlicher, das heisst nullter Ordnung solche höherer Ordnung, so wird diese Unterdrückung der höheren Teilspektren stärker auftreten.

Es ist naheliegend, als erstes bzw. letztes Filter ein Abtasthalteglied erster, bzw. zweiter, bzw. dritter etc. Ordnung zu verwenden. Ein Abtast- und Halteglied erster Ordnung entspricht exakt einem linearen Interpolator zwischen zwei benachbarten Abtastwerten. Ein Abtast- und Halteglied zweiter Ordnung entspricht einer quadratischen, ein Abtast- und Halteglied dritter Ordnung einer kubischen Interpolation.

4

Die Uebertragungsfunktionen dieser Filter ergeben sich aus den vorstehenden Formeln durch Hinzufügen einer entsprechenden Potenz.

Bei der Verarbeitung von Abtastsignalen mit solchen Filtern tritt ein grosser Vorteil zu Tage : Diese Filter haben Koeffizienten, die sich mit endlicher Wortlänge exakt darstellen lassen. Damit entfällt die Quantisierung der Koeffizienten dieser Filter, und die Uebertragungsfunktionen lassen sich exakt angeben.

Das Vorgehen lässt sich auch erweitern zum einfacheren Fall mit festen Verhältnissen der Abtastfrequenzen, indem die Ausgangsabtastfrequenz nicht extern abgelesen, sondern intern erzeugt wird. Die anderen Verarbeitungsschritte bleiben dabei unverändert.

Bei diesem Vorgehen, wie im übrigen auch beim Verfahren mit Wandlern und einem Analog-Filter, besteht die Gefahr der Verjitterung der Taktsignale, die zu einer Verrauschung der abgetasteten Signale führen könnte. Das Verfahren kann verfeinert werden, indem die zeitliche Differenz erst nach Unterdrückung dieses Kurzzeitjitters, z. B. mit Hilfe einer PLL-Schaltung, vorgenommen wird.

Ein weiteres Vorgehen zur Erhöhung der Auflösung und der Genauigkeit besteht darin, dass nach der Quantisierung der Zeitpunkte und vor oder bei der Bestimmung der zeitlichen Differenz eine Mittelung vorgenommen wird, die ebenfalls kurzzeitige Schwankungen unterdrückt.

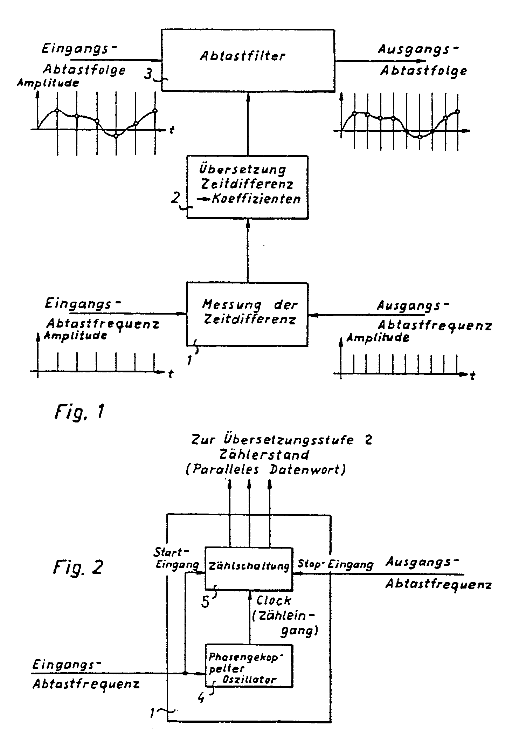

In Fig. 1 sind in Blockdarstellung die essentiellen Funktionsbausteine dargestellt. Ein Abtastfilter 3 mit einem Eingang für eine Eingangsabtastfolge, einem zweiten Eingang für die Steuersignale bzw. Datensignale des Abtastfilters, sowie ein Ausgang für die Ausgangsabtastfolge. Zur eindeutigen Darstellung sind die Eingangs- und Ausgangsabtastfolgen im Zusammenhang mit dem übertragenen Signal dargestellt ; dies jeweils mit verschiedenen Abtastfrequenzen. In diesem Beispiel wird die Abtastrate erhöht, deshalb behält das Signal seine spektrale Information unverändert bei. Ein weiterer Funktionsbaustein 1 dient zur Messung der Zeitdifferenz zwischen den zwei Abtastfrequenzen. Diese sind ebenfalls eingangsseitig graphisch dargestellt. Vom Ausgang dieses Bausteins wird die Information der Zeitdifferenz auf einen Baustein 2 geführt, in dem die gemessenen Zeitdifferenzwerte in entsprechende Filterkoeffizienten übersetzt werden. Diese Filterkoeffizienten dienen zur jeweiligen Konditionierung des Abtastfilters 3.

In Fig. 2 ist in detaillierter Darstellung der Funktionsbaustein 1 zur Messung der Zeitdifferenz zwischen den ein- und ausgangsseitigen Abtastzeitpunkten gezeigt. Die Eingangsabtastfrequenz wird an einem phasengekoppelten Oszillator 4 geführt, dessen Ausgangsfrequenz der Umsetzungsabtastfrequenz entspricht. Schaltungen dieser Art werden in der Fachwelt unter dem Namen PLL (für PHASE-LOCKED LOOPS) verwendet, und erlauben eine exakte und phasenstarre Erhöhung der Frequenz eines periodischen Signals. Die Ausgangsfrequenz des phasengekoppelten Oszillators 4 wird dem daran angeschlossenen digitalen Zähler 5 zugeführt, und wird dort als Zähltakt verwendet. Die Eingangsabtastfrequenz wird zusätzlich dem Zähler zugeführt, die Ausgangsabtastfrequenz ebenfalls. Der Zählvorgang wird durch das Erscheinen einer Flanke des Signals mit der Eingangsabtastfrequenz initialisiert, während die nächste Flanke des Signals mit der Ausgangsabtastfrequenz den Zählvorgang unterbricht und angibt, dass der Zählerstand abgelesen werden kann. Da diese Anordnung zur Messung eines Zeitintervalls in sehr vielen Varianten realisiert werden kann, wird hier bewusst einer eher allgemeine Darstellung der Zählerstufe gewählt. Das parallele Datenwort am Ausgang des Zählers enthält nach einem Zählvorgang ein Mass für die gesuchte Zeitdifferenz, mit einer Zeitquantisierung, welche gleich der reziproken Umsetzungsfrequenz ist.

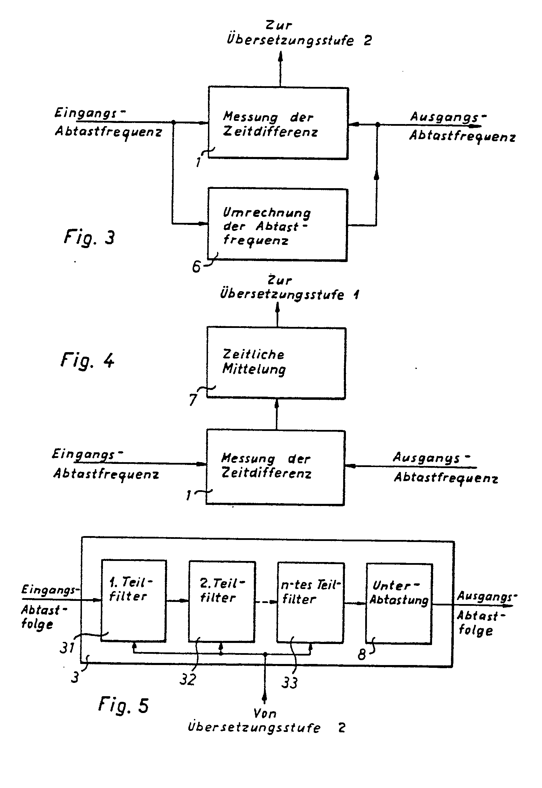

Fig. 5 zeigt, wie das Abtastfilter 3 aufgebaut werden kann. In Kaskade geschaltete Teilfilter 31, 32, 33 werden parallel von der Umsetzungsschaltung 2 gleichzeitig mit der Information der Filterkoeffizienten versehen. Die unterbrochen gezeichnete Verbindung zwischen den Teilfiltern 32 und 33 soll andeuten, dass eine mehrstufige Anordnung bis zum n-ten Teilfilter vorgesehen ist. Eine den Gesamtfilterausgang abtastende Schaltung 8 führt die in der kommentierten Uebersicht erläuterte Unterabtastung aus.

Mit Hilfe der bis jetzt abgegebenen Schaltung soll ein Beispiel für die Umsetzung von abgetasteten Audiosignalen beschrieben werden. Die Eingangsabtastrate sei in der Grössenordnung von 50 kHz, die Ausgangsabtastrate im Bereich zwischen 44 und 50 kHz. Angestrebt ist eine Genauigkeit entsprechend einer Wortlänge von 16 Bits. Berechnungen zeigen, dass die Umsetzungsrate um einen Faktor $2^{15} = 32\,768$ mal höher liegen muss als die Eingangsabtastrate.

Das Abtastfilter 3 wird als vierstufiges Filter aufgebaut, das die Abtastrate sukzessive erhöht. Die ersten zwei Stufen werden im starren Ablauf gesteuert, die zwei letzten Stufen werden durch die zeitliche Differenz der Abtastpunkte gesteuert, d. h. nur die letzten beiden Filter erhalten Signale aus der Umsetzungsstufe 2.

Das erste Abtastfilter erhöht die Abtastrate beispielsweise um einen Faktor 2 und ist als Tiefpassfilter so ausgelegt, dass es das erste Teilspektrum durchlässt, und das zweite Teilspektrum unterdrückt. Beispielsweise hat das Filter einen Durchlassbereich bis 20 kHz, und einen Sperrbereich von 30-50 kHz, bei einer Abtastrate von 100 kHz.

Das zweite Filter erhöht die Abtastrate dann um beispielsweise einen weiteren Faktor 4, und erreicht damit die innere Ausgangsabtastrate von 400 kHz. Sein Durchlassbereich geht ebenfalls von 0-20 kHz, sein Sperrbereich erstreckt sich von 80 kHz bis 200 kHz, wobei ein Sperrbereich mit zwei Sperrzonen von Vorteil ist.

Beide Filter werden als Transversalfilter ausgelegt. Heutige Synthese-Programme erlauben es, bei gegebenen Filtertoleranzen die Filterkoeffizienten zu berechnen. Die zugehörigen Filterordnungen betragen jeweils weniger als 100, und die Filter lassen sich in heutiger Technologie gut realisieren.

Das dritte Filter ist ein kubisches Interpolationsfilter, das eine Erhöhung der Abtastrate um einen Faktor 16 vornimmt. Zur Bestimmung der Koeffizienten dieses Filters lässt sich ein lineares Interpolationsfilter mit gleicher Erhöhung der Abtastrate heranziehen. Die Koeffizienten dieses linearen Interpolationsfilters haben einen linearen Verlauf der erste Koeffizient ist 0, der zweite 1/16, der dritte 2/16 etc. Der 17. Koeffizient beträgt 1 oder 16/16, der 18. nimmt wieder ab und beträgt 15/16, der 19. beträgt 14/16 etc. Der letzte Koeffizient ist der 32. und beträgt 1/16. Um nun die Koeffizienten des kubischen Interpolationsfilters zu bestimmen, müssen lediglich die Koeffizienten des Filters berechnet werden, das durch Kaskade zweier solcher linearer Interpolationsfilter entsteht. Die einzelnen Koeffizienten lassen sich formelmässig durch die diskrete Faltung der Stossantwort des linearen Interpolationsfilters mit sich selbst angeben, was der Kaskade der zwei linearen Interpolationsfilter exakt entspricht.

Das letzte Filter wird ausgelegt als lineares Interpolationsfilter mit einer Erhöhung der Abtastrate um beispielsweise einen Faktor 256. Das Filter hat dementsprechend eine Länge von 512, und seine Koeffizienten lassen sich mit 8 Bits und einem konstanten Vorzeichenbit exakt darstellen.

Die Uebertragungsfunktion im z-Bereich eines linearen Interpolationsfilters mit einer n-fachen Erhöhung der Abtastrate beträgt :

$$H_{n,1}(z) = (1 - z^n/1 - z)^2$$

Bei einem quadratischen Interpolationsfilter beträgt die Uebertragungsfunktion bei gleicher Erhöhung der Abtastrate :

$$H_{n,2}(z) = (1 - z^n/1 - z)^3$$

Bei einem kubischen Interpolationsfilter beträgt sie :

$$H_{n,3}(z) = (1 - z^n/1 - z)^4 = (H_{n,1}(z))^2$$

Bei Interpolationsfiltern höherer Ordnung lautet die Formel ähnlich, und lediglich der Exponent muss entsprechend gewählt werden.

Die Steuerung der ersten zwei Filter kann unabhängig von der Ausgangsabtastfrequenz geschehen. Ein Eingangszeitsignalgenerator erzeugt aus der Eingangsabtastfrequenz alle notwendigen Hilfssignale. Verfahren zur Realisierung und zur Steuerung digitaler Filter, wie man sie in den zwei ersten Stufen verwendet, sind aus der Literatur bekannt und können hier übernommen werden (Referenz : Rabiner and Gold, Theory and Applications of Digital Signal Processing, Prentice-Hall, USA).

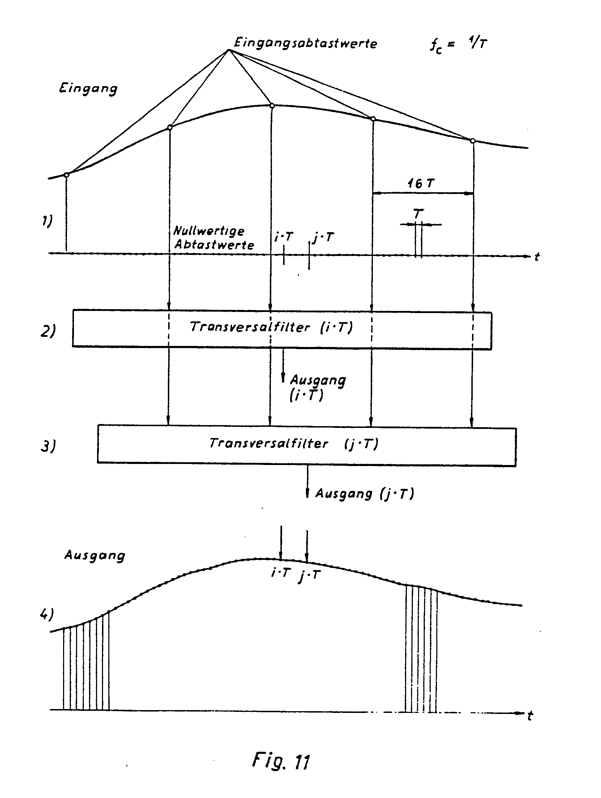

Die Steuerung des dritten und des vierten Filters geschieht nach einem eigenen Verfahren. Die Figur 11 zeigt die relative Lage der Eingangsabtastwerte und der für eine Berechnung benötigten Filterkoeffizienten beim dritten Filter, und zwar für die Berechnung von zwei Ausgangswerten zu zwei verschiedenen Zeitpunkten. Je nach der Lage des zu berechnenden Punktes im Raster wird dabei ein anderer Satz von Koeffizienten des Filters für die Berechnung herangezogen (die anderen Koeffizienten gehören jeweils zu nullwertigen Abtastwerten, und werden deshalb nicht benötigt). Die relative Zeitdifferenz, quantisiert auf die Periode der Umsetzungsfrequenz des dritten Filters, ergibt also direkt Filterkoeffizienten, die in die Rechnung eingehen, und kann also als Steuergrösse verwendet werden. Dies erlaubt es, auf Grund einer nicht vonvornherein bekannten Ausgangsabtastfrequenz die Umsetzung vorzunehmen. Im Gegensatz dazu arbeitet das klassische Verfahren nur bei einer von vornherein festgelegten Ausgangsabtastfrequenz, und das Ueberspringen überflüssiger Operationen geschieht auf Grund von Tabellen an Stelle von Messungen von Zeitdifferenzen.

Das gleiche Prinzip gilt für die vierte Filterstufe, wobei nun die Messung der relativen Zeitdifferenz mit der Umsetzungsabtastrate der letzten Filterstufe geschieht.

Da wir in diesem Beispiel mit Zweiterpotenz-Verhältnissen der Abtastfrequenzen und der Filterlängen arbeiten, können auch die zwei benötigten Messungen der relativen Zeitdifferenzen kombiniert werden. Ein digitaler Zähler wird bei jeder neuen Flanke der Abtastfrequenz nach dem zweiten Filter auf Null gesetzt, und zählt einen Zähltakt mit der höchsten Umsetzungsfrequenz (sie beträgt in diesem Beispiel 32 768 mal die Eingangsabtastfrequenz). Da der Zähler bei jeder neuen Flanke auf Null gesetzt wird, beträgt der Zählerstand höchstens 4 095, d. h. 212-1. Beim Erscheinen eines Ausgangsabtastpulses wird der Zähler gestoppt und abgelesen. Der Zählerinhalt ist eine 12 Bit-Zahl, deren vier höherwertigen Bits die Information zur Steuerung des dritten Filters, und deren acht minderwertige Bits die Information zur Steuerung des vierten Filters enthalten.

Der exakte Vorgang der Steuerung des dritten und des vierten Filters, d. h. der Uebergang von der relativen Zeitdifferenz zu einer bestimmten Rechenabfolge im Filter, ist in seinen Einzelheiten sehr stark mit den Details der Realisierung des Filters verbunden und wird deshalb hier ausgelassen. Die Definition der Filter, die Definition der zu verwendenden Koeffizientensätze und Angaben aus der technischen Literatur (beispielsweise das bereits zitierte Buch von Rabiner & Gold) erlauben es dem Fachmann ohne weiteres, das hier beschriebene Filter zu realisieren.

Die Fig. 3 und 4 zeigen weitere Möglichkeiten zur Bildung der Information aus der relativen Zeitdifferenz der beiden Abtastsignale für die Umsetzung in Werte analog den Filterkoeffizienten. So werden in Fig. 4 die in ständiger Folge anfallenden Werte von Zeitdifferenzen zeitlich gemittelt, was in der Zeitmittelungsschaltung 7 durchgeführt wird. Diese Mittelung macht es möglich, aus verschiedenen Messungen der Lage des gleichen Zeitpunktes mit reduzierter Auflösung einen Wert mit erhöhter Auflösung zu bestimmen, und reduziert somit die maximale Geschwindigkeit der Verarbeitung innerhalb der Zählerschaltung. Die zeitliche Mittelung einzelner Zeitdifferenzen zu einem Ergebnis mit erhöhter Genauigkeit wird mit Hilfe einer Rechenschaltung vorgenommen, wie sie heute in der digitalen Filtertechnik verwendet wird.

Gemäss Fig. 3 kann auch das Ausgangstaktsignal bzw. die Ausgangsabtastfrequenz von der Eingangsabtastfrequenz direkt abgeleitet werden. Dazu wird die Eingangsabtastfrequenz in einer Abtastfrequenzumrechnungsschaltung 6 umgerechnet und der Schaltung 1 zur Messung der Zeitdifferenz zugeführt, sowie gleichzeitig als Taktsignal weiter verwertet. Damit ist es möglich, die gleiche Anordnung zur Umsetzung der Abtastfrequenz auch im Falle zu verwenden, wo die Ausgangsabtastfrequenz aus der Eingangsabtastfrequenz direkt hergeleitet wird, statt wie bisher extern zugeliefert zu werden.

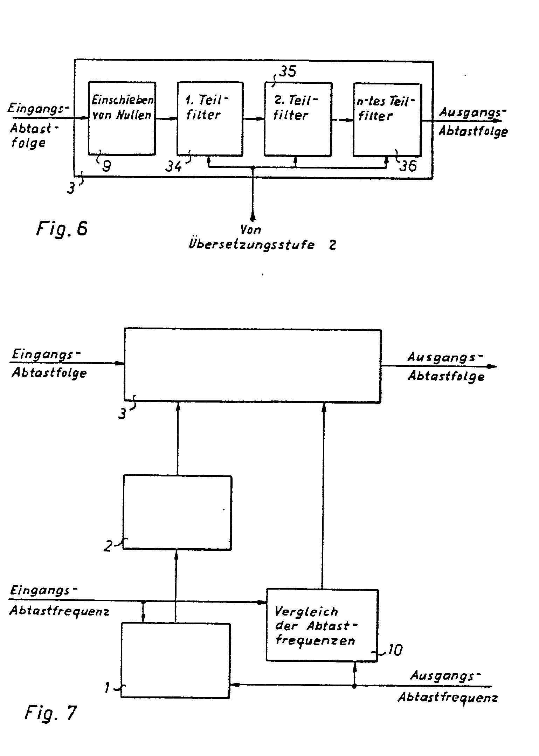

In Fig. 6 ist eine Schaltanordnung des Abtastfilters 3 dargestellt, in der mit Hilfe des Schaltkreises 9 die Abtastfrequenz des Eingangsabtastfolge künstlich erhöht wird, indem nullwertige Abtastwerte zwischen die Eingangsabtastwerte eingeschoben werden. Die nun höherfrequente Eingangsabtastfolge wird über eine mehrstufige Kaskade von Teilfilter 34, 35, 36, welche von der Umsetzstufe die von der momentanen zeitlichen Differenz abhängigen Filterkoeffizienten parallel zugeführt erhalten, auf die gewünschte Ausgangsabtastfrequenz heruntergeteilt.

Fig. 7 zeigt nun eine Schaltungsanordnung, mit der wahlweise die Zusatzquantisierung durch Einschieben zusätzlicher nullwertiger Abtastwerte zwischen die von der Eingangsabtastfolge gegebenen Abtastwerte benützt wird (gemäss Fig. 6) oder aber die Unterabtastung einer, mittels n-stufiger Filterkaskade erhöhten maximalen Umsetzungsabtastrate, wie dies in Fig. 5 gezeigt ist. Dabei werden wiederum aus der Schaltung 1 zur Messung der Zeitdifferenz, einem von $\Delta t$ als Funktion der Eingangs- und Ausgangsabtastfrequenz abhängigen Wert im Koeffizientenumsetzer 2 die zugehörigen Filterkoeffizienten zugeordnet. Die ausgewählten Filterkoeffizienten bzw. deren Werte dann zur Konditionierung der Filterkaskade im Abtastfilter 3 verwendet. Eine Vergleichsschaltung 10 der Abtastfrequenzen steuert die für die Unterabtastung zuständige Schaltung 8 im Abtastfilter 3, derart dass die Abtastfolge, welche die verhältnismässig hohe innere Umsetzungsabtastfrequenz aufweist, nur zu den ausgangsseitigen Abtastzeitpunkten abgelesen wird.

Der Koeffizientenumsetzer 2 wird vorzugsweise aus einem Festwertspeicherbaustein mit zugehöriger, zeitabhängiger Steuerung gebildet. Im Festwertspeicher werden die einzelnen Filterkoeffizienten abgelegt, unter Zuordnung von Adressen. Der exakte Zusammenhang zwischen den relativen Zeitdifferenzen, wie sie von der Zeitdifferenzmessschaltung geliefert werden, und den einzelnen Koeffizienten, wird durch eine entsprechende Wahl der Speicheradressen realisiert, und erfordert somit keinerlei Schaltungsaufwand. Je nach Grösse und Geschwindigkeit der benötigteen Festwertspeicher können kommerziell erhältlich bipolare oder MOS-ROM-Bausteine verwendet werden.

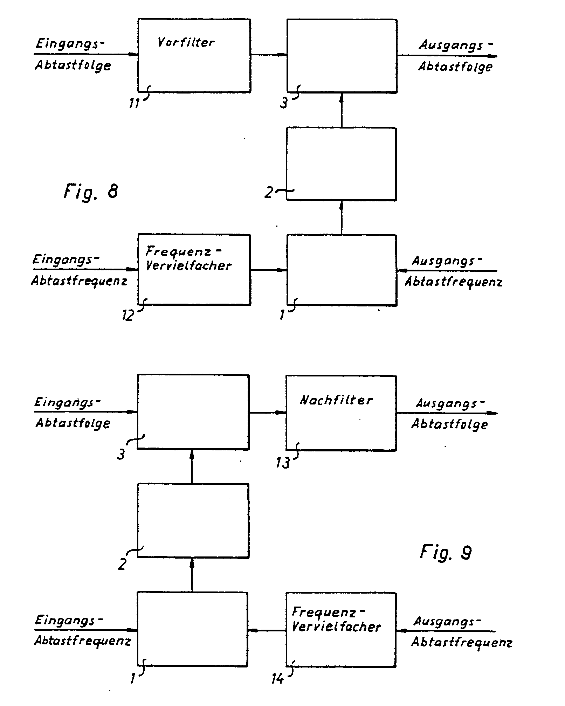

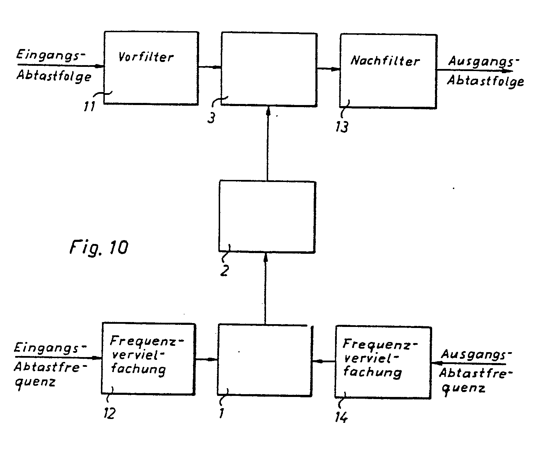

Zunehmend flexibler wird die Schaltungsanordnung zur Umsetzung der Abtastfrequenz einer Eingangsabtastfolge mit der Zuschaltung eines Vorfilters 11, zusammen mit einem Frequenzvervielfacher 12 für die Eingangsabtastfrequenz gemäss Fig. 8, bzw. eines Nachfilters 13, zusammen mit einem Frequenzvervielfacher für die Ausgangsabtastfrequenz gemäss Fig. 9, bzw. der beiden Massnahmen gleichzeitig, wie dies Fig. 10 darstellt.

Für Anpassungszwecke wird, bevor die Eingangsabtastfolge in den Abtastfilter 3 gegeben wird, diese in einem Vorfilter 11 um ein festes Verhältnis in der Frequenz erhöht und um dasselbe Verhältnis in einem Nachfilter 13 herabgesetzt. Dasselbe Frequenzveränderungsverhältnis zur Vervielfachung muss natürlich auch für die Zeitdifferenzmessung erfolgen, was durch die Frequenzvervielfacher-Schaltungen 12 und 14, je für die Eingangsabtast- und Ausgangsabtast-Frequenz, ausgeführt wird.

**Patentansprüche**

1. Verfahren zur Umsetzung einer Eingangsabtastfolge mit einer Eingangsabtastfrequenz in eine Ausgangsabtastfolge mit einer wählbaren Ausgangsabtastfrequenz mit Hilfe eines Abtastfilters derart, dass die beiden Abtastfolgen Frequenzspektren aufweisen, die in einem Frequenzbereich amplitudenmässig identisch sind, der sich von der Frequenz Null bis zur Hälfte der niedrigeren der beiden Abtastfrequenzen erstreckt, bis auf einen Fehleranteil, der nur durch die Genauigkeit des Verarbeitung der Abtastwerte begrenzt wird, dadurch gekennzeichnet, dass die momentane zeitliche Differenz zwischen dem Eingangs- und dem Ausgangsabtastzeitpunkt als Steuergrösse für den Abtastfilter benützt wird.

2. Verfahren nach Anspruch 1, dadurch gekennzeichnet, dass die momentane zeitliche Differenz zur Auswahl eines momentanen Abtastfilterkoeffizientensatzes verwendet wird und dass mit den ausgewählten Koeffizienten ein mindestens einstufiges Abtastfilter konditioniert wird.

7

3. Verfahren nach Anspruch 1 und 2, dadurch gekennzeichnet, dass die Ausgangsabtastfrequenz aus der Eingangsabtastfrequenz aufgrund eines festen Verhältnisses hergeleitet wird.

4. Verfahren nach Anspruch 1 und 2, dadurch gekennzeichnet, dass die momentane zeitliche Differenz zwischen den Eingangs- und Ausgangsabtastzeitpunkten nach Unterdrückung kurzzeitiger Schwankungen des zeitlichen Abstandes zwischen nacheinanderfolgenden Abtastzeitpunkten ermittelt wird.

5. Verfahren nach Anspruch 1 und 2, dadurch gekennzeichnet, dass die Genauigkeit der Ermittlung der momentanen zeitlichen Differenz zwischen den Eingangs- und Ausgangsabtastzeitpunkten durch zeitliche Mittelung erhöht wird.

6. Verfahren nach Anspruch 1 und 2, dadurch gekennzeichnet, dass die Umsetzung der Eingangs- in die Ausgangsabtastfolge durch eine Erhöhung der Abtastrate mittels eines mindestens einstufigen Abtastfilters zu einer Umsetzungsrate, die der zeitlichen Quantisierung der momentanen zeitlichen Differenz entspricht, durchgeführt und die nachfolgende Anpassung an die ausgangsseitige Abtastfrequenz durch Ablesen der Abtastfolge mit der Umsetzungsabtastfrequenz nur zu den ausgangsseitigen Abtastzeitpunkten herbeigeführt wird.

7. Verfahren nach Anspruch 1 und 2, dadurch gekennzeichnet, dass für die Umsetzung der Eingangs- in die Ausgangsabtastfolge die Eingangsabtastfolge durch Einfügen einer zusätzlichen von der Zeitdifferenz abhängigen Anzahl nullwertiger Abtastwerte in eine Umsetzungsabtastfolge übergeführt wird, deren Umsetzungsabtastfrequenz der Quantisierung der momentanen zeitlichen Differenz entspricht, und dass die Anpassung an die ausgangsseitige Abtastfrequenz durch Herabsetzung der Abtastfrequenz unter Verwendung von mindestens einem einstufigen Abtastfilter geschieht.

8. Verfahren nach den Ansprüchen 1 und 2, gekennzeichnet durch die wahlweise Verwendung der Verfahrensschritte gemäss Anspruch 6 oder Anspruch 7, wobei die Auswahl vom Verhältnis der beiden Abtastfrequenzen derart bestimmt wird, dass bei gegenüber der Eingangsabtastfrequenz höherer Ausgangsabtastfrequenz gemäss Anspruch 6, bei tieferer Ausgangsabtastfrequenz gemäss Anspruch 7 verfahren wird.

9. Verfahren nach einem der Ansprüche 6, 7 und 8, dadurch gekennzeichnet, dass Multiplikationen, bei welchen die Abtastwerte nullwertig sind, nicht ausgeführt werden.

10. Verfahren nach einem der Ansprüche 6, 7, 8, dadurch gekennzeichnet, dass die Erhöhung bzw. Herabsetzung der Abtastfrequenz jeweils um eine Zweierpotenz geschieht.

11. Verfahren nach den Ansprüchen 6 bis 8, dadurch gekennzeichnet, dass vor der Umsetzung der Abtastfrequenz die Eingangsabtastfrequenz um einfestes Verhältnis unter Verwendung eines Vorfilters erhöht wird.

12. Verfahren nach den Ansprüchen 6 bis 8, dadurch gekennzeichnet, dass nach der Umsetzung der Abtastfrequenz die Ausgangsabtastfrequenz um ein festes Verhältnis unter Verwendung eines Nachfilters herabgesetzt wird.

13. Verfahren nach den Ansprüchen 6 bis 8, dadurch gekennzeichnet, dass vor der Umsetzung der Abtastfrequenz eine zusätzliche Erhöhung der Eingangsabtastfrequenz um ein festes Verhältnis unter Verwendung eines Vorfilters geschieht, und dass nach der Umsetzung der Abtastfrequenz eine entsprechende Herabsetzung der Ausgangsabtastfrequenz um das gleiche Verhältnis unter Verwendung eines Nachfilters geschieht.

14. Verfahren nach Anspruch 13, dadurch gekennzeichnet, dass zur Erhöhung bzw. Herabsetzung der Abtastfrequenz Abtastfilter verwendet werden, die einer wenigstens einstufigen Kaskade von identischen Abtastfiltern mit identischen Koeffizienten äquivalent sind.

15. Verfahren nach den Ansprüchen 11, 12 oder 13, dadurch gekennzeichnet, dass zur Erhöhung bzw. Herabsetzung der Abtastfrequenz Abtastfilter verwendet werden, deren Koeffizienten bei einer Darstellung in fester Wortlänge bei beliebiger Form der Quantisierung ohne Quantisierungsfehler dargestellt werden können.

16. Verfahren nach den Ansprüchen 1 und 2, dadurch gekennzeichnet, dass das Abtastfilter zur Umsetzung der Eingangs- in die Ausgangsabtastfolge als ein Fourier-Prozessor zur Berechnung des Frequenzspektrums der Eingangsabtastfolge, gefolgt von einem Prozessor zur Durchführung der Filteroperationen im Fourier-Bereich, und von einem zweiten Fourier-Prozessor zur Rücktransformation in den Zeitbereich ausgelegt ist.

17. Schaltungsanordnung zur Durchführung des Verfahrens nach Anspruch 1, gekennzeichnet durch eine Schaltung (1) zur Bildung der zeitlichen Differenz der Abtastzeitpunkte, der von den zwei Taktsignalen des Ein- und Ausgangs gespiesen wird ; eine Uebersetzungsschaltung (2) zur Umrechnung der zeitlichen Differenz in eine Information zur Kennzeichnung von Koeffizienten ; und eine Abtastfilter (3) der die Eingangsabtastfolge in die Ausgangsabtastfolge überführt, und dessen momentan zu verwendender Koeffizientensatz durch die Uebersetzungsschaltung (2) geliefert wird.

18. Schaltungsanordnung nach Anspruch 17, dadurch gekennzeichnet, dass die Schaltung (1) zur Bildung der zeitlichen Differenz aus einem mit der Eingangsabtastfrequenz phasengekoppelter Oszillator (4), dessen Frequenz ein ganzzahliges Vielfaches der Eingangsabtastfrequenz beträgt, und einer Zählerstufe (5), die die zeitlichen Intervalle zwischen den Ausgangsabtastzeitpunkten als Anzahl zeitlicher Intervalle des schnellen Takts am Ausgang des Oszillators (4) bestimmt, besteht.

19. Schaltungsanordnung nach Anspruch 17, dadurch gekennzeichnet, dass das Ausgangstaktsignal aus einer Umrechnungsschaltung (6), deren Eingang das Eingangstaktsignal ist, und die die Eingangstaktfrequenz mit einem festen Wert multipliziert, geliefert wird.

20. Schaltungsanordnung nach Anspruch 18, dadurch gekennzeichnet, dass zwischen der Schaltung (1) zur Bildung der zeitlichen Differenz und der Umsetzungsschaltung (2) eine zusätzliche Schaltung (7) eingefügt wird, die die Funktion hat, die momentane zeitliche Differenz einer zeitlichen Mittelung zu unterziehen.

21. Verfahren nach Anspruch 17, dadurch gekennzeichnet, dass das Abtastfilter (3) als wenigstens einstufige Kaskade von Teilfiltern (31, 32, 33) mit zunehmender Abtastfrequenz besteht, gefolgt von einer Schaltung (8) zur Unterabtastung der von der Kaskade eingegebenen Folge mit der höchsten Abtastfrequenz.

22. Schaltungsanordnung nach Anspruch 17, dadurch gekennzeichnet, dass das Abtastfilter (3) aus der Hintereinanderschaltung einer Schaltung (9) zur Einschiebung nullwertigen Abtastwerte und einer Kaskade von n Teilfiltern (34, 35, 36) mit stufenweise abnehmender Abtastfrequenz besteht, wobei die Anzahl n der Teilfilter grösser oder gleich 1 ist.

23. Schaltungsanordnung nach den Ansprüchen 21 oder 22, dadurch gekennzeichnet, dass eine Vergleichsschaltung (10) zum Vergleich der Abtastfrequenzen dem Abtastfilter (3) zugeordnet ist, wobei in Abhängigkeit des Ergebnisses des Vergleichs das Abtastfilter (3) bei gegenüber der Eingangsabtastfrequenz höherer Ausgangsabtastfrequenz gemäss Anspruch 21, bei tieferer Ausgangsabtastfrequenz gemäss Anspruch 22 arbeitet.

24. Schaltungsanordnung nach Anspruch 17, dadurch gekennzeichnet, dass vor dem Eingang des Abtastfilters (3) ein Vorfilter (11) geschaltet ist, das die Abtastfrequenz um eine festen Betrag erhöht, und dass sich vor dem Eingang des Differenzbildners (1) eine entsprechende Schaltung zur Frequenzvervielfachung (12) befindet, welche die Eingangsabtastfrequenz um das gleiche Verhältnis erhöht.

25. Schaltungsanordnung nach Anspruch 17, dadurch gekennzeichnet, dass nach dem Abtastfilter (3) ein Nachfilter (13) geschaltet ist, das die Abtastrate um ein festes Verhältnis herabsetzt, und dass dem Eingang des Differenzbildners (1) eine Schaltung zur Frequenzvervielfachung (14) für die Ausgangsabtastfrequenz vorgeschaltet ist, welche die Ausgangsabtastfrequenz um das gleiche Verhältnis erhöht.

26. Schaltungsanordnung nach den Ansprüchen 24 und 25, gekennzeichnet durch mit dem Abtastfilter (3) verbundene Vorfilter (11) und Nachfilter (13) und auf den Differenzbildner (1) wirkende Frequenzvervielfacher (12, 14) für die Eingangsabtastfrequenz und die Ausgangsabtastfrequenz.

27. Schaltungsanordnung nach Anspruch 17, dadurch gekennzeichnet, dass das Abtastfilter (3) wenigstens aus einer einstufigen Kaskade von Teilfiltern (37, 38, 39) besteht, wobei wenigstens ein Teilfilter als wenigstens einstufige Kaskade von identischen Subfiltern dargestellt werden kann, die alle identische und gleichwertige Koeffizienten aufweisen.

## Claims

1. Method for converting an input sampling sequence with an input sampling frequency into an output sampling sequence with a selectable output sampling frequency with the aid of a sampling filter, in such a way that the two sampling sequences have frequency spectra, which are identical from the amplitude standpoint in a frequency range extending from the frequency zero to half the lower of the two sampling frequencies, with the exception of an error contribution, which is only limited by the accuracy processing the sampling values, characterized in that the instantaneous time difference between the input and output sampling time is used as a control quantity for the sampling filter.

2. Method according to claim 1, characterized in that the instantaneous time difference is used for selecting an instantaneous set of sampling filter coefficients and that an at least single-stage sampling filter is conditioned with the selected coefficients.

3. Method according to claims 1 and 2, characterized in that the output sampling frequency is derived from the input sampling frequency on the basis of a fixed ratio.

4. Method according to claims 1 and 2, characterized in that the instantaneous time difference between the input and output sampling points is determined between successive sampling times after suppressing short-time fluctuations of the time interval.

5. Method according to claims 1 and 2, characterized in that the accuracy of determining the instantaneous time difference between the input and output sampling times is increased by time averaging.

6. Method according to claims 1 and 2, characterized in that the conversion of the input sampling sequence into the output sampling sequence is carried out by increasing the sampling rate by means of at least one-stage sampling filter to a conversion rate corresponding to the time quantization of the instantaneous time difference and the subsequent adaptation to the output-side sampling frequency is brought about by reading the sampling sequence with the conversion sampling frequency only at the output-side sampling times.

7. Method according to claims 1 and 2, characterized in that for converting the input sampling sequence into the output sampling sequence, the input sampling sequence is transferred into a

9

conversion sampling sequence by inserting an additional number of zero level sampling values which is dependent on the time difference and the conversion sampling frequency thereof corresponds to the quantizing of the instantaneous time difference and that the adaptation to the output-side sampling frequency is brought about by reducing the sampling frequency using at least one single-stage sampling filter.

8. Method according to claims 1 and 2, characterized by the random use of the method stages according to claims 6 or 7, the choice of the ratio of the two sampling frequencies being determined in such a way that when the output sampling frequency is higher than the input sampling frequency the procedure of claim 6 is used, whereas when the output sampling frequency is lower the procedure of claim 7 is used.

9. Method according to one of the claims 6, 7 and 8, characterized in that the multiplications at which the sampling values are zero level are not performed.

10. Method according to one of the claims 6, 7 and 8, characterized in that the increasing or decreasing of the sampling frequency in each case takes place by a power of two.

11. Method according to one of the claims 6 to 8, characterized in that prior to converting the sampling frequency, the input sampling frequency is increased by a fixed ratio using a prefilter.

12. Method according to claims 6 to 8, characterized in that after converting the sampling frequency, the output sampling frequency is decreased by a fixed ration using a postfilter.

13. Method according to claims 6 to 8, characterized in that before converting the sampling frequency, there is an additional increase of the input sampling frequency by a fixed ratio using a prefilter and that after converting the sampling frequency, there is a corresponding reduction of the output sampling frequency by the same ratio using a postfilter.

14. A method according to claim 13, characterized in that sampling filters are used for increasing or decreasing the sampling frequency and said filters are equivalent to an at least single-stage cascade of identical sampling filters with identical coefficients.

15. A method according to claims 11, 12 or 13, characterized in that for increasing or decreasing the sampling frequency, sampling filters are used, whose coefficients can be represented without quantization errors in the case of a representation in fixed word length and in a random form of quantization.

16. Method according to claims 1 and 2, characterized in that the sampling filter for converting the input sampling sequence into the output sampling sequence is designed as a Fourier processor for calculating the frequency spectrum of the input sampling sequence, followed by a processor for performing the filtering operation in the Fourier range, as well as a second Fourier processor for the back-transformation in the time range.

17. Circuit arrangement for performing the method according to claim 1, characterized by a circuit (1) for forming the time difference of the sampling times and which is supplied by the two clock signals of the input and output ; a conversion circuit (2) for converting the time difference into an information for characterizing coefficients ; and a sampling filter (3) converting the input sampling sequence into the output sampling sequence and whose instantaneous set of coefficients to be used is supplied by the conversion circuit (2).

18. Circuit according to claim 17, characterized in that the circuit (1) for forming the time difference comprises an oxcillator (4) phase-locked with the input sampling frequency and whose frequency is an integral multiple of the input sampling frequency, as well as a counter stage (5), which determines the time intervals between the output sampling time as a number of time intervals of the rapid clock at the output of oscillator (4).

19. Circuit arrangement according to claim 17, characterized in that the output clock signal is supplied by a conversion circuit (6), whose input is the input clock signal and which multiplies the input clock frequency by a fixed value.

20. Circuit arrangement according to claim 18, characterized in that between the circuit (1) for forming the time difference and the conversion circuit (2) is introduced at an additional circuit (7), whose function is to subject the instantaneous time difference to time averaging.

21. Circuit arrangement according to claim 17, characterized in that the sampling filter (3) comprises an at least single-stage cascade of partial filters (31, 32, 33) with increasing sampling frequency, followed by a circuit (8) for undersampling the sequence fed in by the cascade having the highest sampling frequency.

22. Circuit arrangement according to claim 17, characterized in that the sampling filter (3) comprises a series connection of a circuit (9) for introducing zero level sampling values and a cascade of n partial filters (34, 35, 36) with stepwise decreasing sampling frequency, the number n of the partial filters being equal to or higher than 1.

23. Circuit arrangement according to claims 21 or 22, characterized in that with sampling filter (3) is associated a comparator circuit (10) for comparing the sampling frequencies, and, as a function of the result of the comparison, in the case of a higher output sampling frequency than input sampling frequency operation is in accordance with claim 21, whereas in the case of a lower output sampling frequency operation is according to claim 22.

24. Circuit arrangement according to claim 17, characterized in that a prefilter (11) is connected upstream of the input of sampling filter (3) and increases the sampling frequency by a fixed amount, and

0 052 847

that a corresponding frequency multiplication circuit (12) is positioned upstream of the input of circuit (1) and increases the input sampling frequency by the same ratio.

25. Circuit arrangement according to claim 17, characterized in that a postfilter (13) is connected downstream of the sampling filter (3) and reduces the sampling rate by a fixed ratio and that a frequency multiplication circuit (14) for the output sampling frequency is connected upstream of the input of circuit (1) and increases the output sampling frequency by the same ratio.

26. Circuit arrangement according to claims 24 and 25, characterized by prefilter (11) and postfilter (13) connected to the sampling filter (3) and frequency multipliers (12, 14) for the input and output sampling frequencies acting on circuit (1).

27. Circuit arrangement according to claim 17, characterized in that the sampling filter (3) comprises at least one single-stage cascade of partial filters (37, 38, 39), at least one partial filter being representable as an at least single-stage cascade of identical subfilters, which all have identical and equivalent coefficients.

**Revendications**

1. Procédé de conversion d'une série d'échantillonnage d'entrée ayant une fréquence d'échantillonnage en une série d'échantillonnage de sortie ayant une fréquence d'échantillonnage susceptible d'être choisie, au moyen d'un filtre d'échantillonnage, de telle manière que les deux séries d'échantillonnage présentent des spectres de fréquence dont les amplitudes sont identiques dans un domaine de fréquences qui s'étend depuis la fréquence zéro jusqu'à la moitié de la plus basse des deux fréquences d'échantillonnage, avec une proportion d'erreur qui n'est limitée que par la précision du traitement des données échantillonnées, caractérisé en ce que la différence de temps instantanée entre le moment d'échantillonnage d'entrée et le moment d'échantillonnage de sortie est utilisée comme paramètre de commande du filtre d'échantillonnage.

2. Procédé selon la revendication 1, caractérisé en ce que la différence de temps momentanée est utilisée pour le choix de la valeur d'un coefficient d'échantillonnage momentané et en ce que ce coefficient choisi permet de conditionner un filtre d'échantillonnage présentant au moins un étage.

3. Procédé selon l'une des revendications 1 et 2, caractérisé en ce que la fréquence d'échantillonnage de sortie se déduit de la fréquence d'échantillonnage d'entrée sur la base d'un rapport fixe.

4. Procédé selon l'une des revendications 1 et 2, caractérisé en ce que la différence de temps instantanée entre le moment d'échantillonnage d'entrée et le moment d'échantillonnage de sortie est déterminée, après inhibition de variations de courte durée de l'intervalle de temps, entre des moments d'échantillonnage successifs.

5. Procédé selon l'une des revendications 1 et 2, caractérisé en ce que la précision de la détermination de la différence de temps instantanée entre le moment d'échantillonnage d'entrée et le moment d'échantillonnage de sortie est améliorée par la réalisation d'une moyenne dans le temps.

6. Procédé selon l'une des revendications 1 et 2, caractérisé en ce que la conversion de la série d'échantillonnage d'entrée en série d'échantillonnage de sortie s'effectue par une augmentation du taux d'échantillonnage, au moyen d'un filtre d'échantillonnage présentant au moins un étage, jusqu'à un taux de conversion qui correspond à la quantification chronologique de la différence de temps instantanée et en ce que l'adaptation ultérieure à la fréquence d'échantillonnage du côté sortie ne s'effectue par lecture de la série d'échantillonnage ayant la fréquence d'échantillonnage de conversion qu'aux moments d'échantillonnage du côté sortie.

7. Procédé selon l'une des revendications 1 et 2, caractérisé en ce que, pour la conversion de la série d'échantillonnage d'entrée en série d'échantillonnage de sortie, la série d'échantillonnage d'entrée est transformée, par incorporation d'un certain nombre, variable avec la différence de temps, de données échantillonnées supplémentaires de valeur nulle, en une série d'échantillonnage de conversion dont la fréquence d'échantillonnage de conversion correspond à la quantification de la différence de temps instantanée et en ce que l'adaptation à la fréquence d'échantillonnage du côté sortie s'effectue par abaissement de la fréquence d'échantillonnage au moyen d'au moins un filtre d'échantillonnage à un étage.

8. Procédé selon l'une des revendications 1 et 2, caractérisé par l'utilisation au choix des manières de procédé suivant la revendication 6 ou la revendication 7, le choix du rapport des deux fréquences d'échantillonnage se faisant de telle manière que, lorsque la fréquence d'échantillonnage de sortie est plus élevée que la fréquence d'échantillonnage d'entrée, on procède selon la revendication 6 et que, lorsque la fréquence d'échantillonnage de sortie est plus basse, on procède selon la revendication 7.

9. Procédé selon l'une des revendications 6, 7 et 8, caractérisé en ce que les multiplications pour lesquelles les données échantillonnées ont une valeur nulle ne sont pas effectuées.

10. Procédé selon l'une des revendications 6, 7 et 8, caractérisé en ce que l'élévation ou l'abaissement de la fréquence d'échantillonnage s'effectue toujours par une puissance de deux.

11. Procédé selon l'une des revendications 6 à 8, caractérisé en ce qu'avant la conversion de la fréquence d'échantillonnage, la fréquence d'échantillonnage d'entrée est augmentée dans une proportion fixe au moyen d'un premier filtre.

11

12. Procédé selon l'une des revendications 6 à 8, caractérisé en ce qu'après la conversion de la fréquence d'échantillonnage, la fréquence d'échantillonnage de sortie est abaissée dans une proportion fixe au moyen d'un filtre suivant.

13. Procédé selon l'une des revendications 6 à 8, caractérisé en ce qu'il comporte, avant la conversion de la fréquence d'échantillonnage, une élévation supplémentaire de la fréquence d'échantillonnage d'entrée dans une proportion fixe au moyen d'un premier filtre et, après la conversion de la fréquence d'échantillonnage, un abaissement correspondant de la fréquence d'échantillonnage de sortie dans la même proportion par un filtre suivant.

14. Procédé selon la revendication 13, caractérisé en ce que pour l'élévation ou l'abaissement de la fréquence d'échantillonnage, on utilise des filtres d'échantillonnage qui sont équivalents à au moins une cascade à un étage de filtres d'échantillonnage identiques ayant des coefficients identiques.

15. Procédé selon l'une des revendications 11, 12 ou 13, caractérisé en ce que, pour l'élévation ou l'abaissement de la fréquence d'échantillonnage, des filtres d'échantillonnage dont les coefficients peuvent, dans une représentation à longueur de mot fixe, être représentés, pour n'importe quelle forme de quantification, sans erreur de quantification.

16. Procédé selon l'une des revendications 1 et 2, caractérisé en ce que le filtre d'échantillonnage assurant la conversion de la série d'échantillonnage d'entrée en série d'échantillonnage de sortie est monté comme un processeur de Fourier pour le calcul du spectre de fréquence de la série d'échantillonnage d'entrée suivi par un processeur assurant les opérations de filtrage dans le domaine de Fourier et par un deuxième processeur de Fourier assurant la transformation inverse dans le domaine temporel.

17. Circuit global pour l'application du procédé selon la revendication 1, caractérisé en ce qu'il comprend : un circuit (1) pour la formation de la différence chronologique de temps des moments d'échantillonnage et recevant les deux signaux d'horloge de l'entrée et de la sortie ; un circuit de traduction (2) assurant la conversion de la différence de temps en une information permettant l'attribution des coefficients ; et un filtre d'échantillonnage (3) qui transforme la série d'échantillonnage d'entrée en série d'échantillonnage de sortie et dont le jeu de coefficients à utiliser est fourni par le circuit de traduction (2).

18. Circuit selon la revendication 17, caractérisé en ce que le circuit (1) pour la formation de la différence de temps est constitué par un oscillateur (4) qui est couplé en phase avec la fréquence d'échantillonnage d'entrée et dont la fréquence est un multiple entier de la fréquence d'échantillonnage d'entrée et par un étage de compteur (5) qui détermine les intervalles de temps entre les moments d'échantillonnage de sortie comme étant le nombre des intervalles de temps des battements rapides à la sortie de l'oscillateur (4).

19. Circuit selon la revendication 17, caractérisé en ce que le signal d'horloge de sortie provient d'un circuit de conversion (6) dont l'entrée est le signal d'horloge d'entrée et qui multiplie par une valeur fixe la fréquence d'horloge d'entrée.

20. Circuit selon la revendication 18, caractérisé en ce qu'il comporte, entre le circuit (1) pour la formation de la différence de temps et le circuit de conversion (2), un circuit supplémentaire qui a pour fonction de soumettre la différence de temps à la réalisation d'une moyenne dans le temps.

21. Circuit selon la revendication 17, caractérisé en ce que le filtre d'échantillonnage (3) est constitué par une cascade à un étage au moins de filtres partiels (31, 32, 33) de fréquence d'échantillonnage croissante suivi d'un circuit (8) assurant le sous-échantillonnage de la série fournie par la cascade avec la fréquence d'échantillonnage la plus élevée.

22. Circuit selon la revendication 17, caractérisé en ce que le filtre d'échantillonnage (3) est constitué par le montage en série d'un circuit (9) assurant l'introduction de données échantillonnées de valeur nulle et d'une cascade de n filtres partiels (34, 35, 36) de fréquence d'échantillonnage décroissante par degrés, le nombre n de ces filtres partiels étant supérieur ou égal à 1.

23. Circuit selon l'une des revendications 21 ou 22, caractérisé en ce qu'un circuit de comparaison (10) pour la comparaison des fréquences d'échantillonnage est associé au filtre d'échantillonnage (3), de sorte que suivant le résultat de la comparaison le filtre d'échantillonnage (3) fonctionne selon la revendication 21 lorsque la fréquence d'échantillonnage de sortie est supérieure à la surface d'échantillonnage d'entrée et selon la revendication 22 lorsque la fréquence d'échantillonnage de sortie est inférieure.

24. Circuit selon la revendication 17, caractérisé en ce qu'il comporte, en avant de l'entrée du filtre d'échantillonnage (3), un premier filtre (11) qui élève la fréquence d'échantillonnage d'une quantité fixe et en ce qu'il comporte, en avant de l'entrée de l'organe différentiateur (1), un circuit (12) de multiplication de fréquence qui augmente dans la même proportion la fréquence d'échantillonnage d'entrée.

25. Circuit selon la revendication 17, caractérisé en ce qu'il comporte, en arrière du filtre d'échantillonnage (3), un filtre suivant (13) qui abaisse les taux d'échantillonnage dans une proportion fixe et en ce qu'il comporte, en avant de l'entrée de l'organe différentiateur (1), un circuit (14) de multiplication de la fréquence d'échantillonnage de sortie qui augmente dans la même proportion la fréquence d'échantillonnage de sortie.

26. Circuit selon l'une des revendications 24 et 25, caractérisé en ce qu'il comporte un ou des premiers filtres (11) et un ou des filtres suivants (13) et des multiplicateurs de fréquence (12, 14) agissant

**0 052 847**

sur l'organe différentiateur (1) pour la fréquence d'échantillonnage d'entrée et la fréquence d'échantillonnage de sortie.

27. Circuit selon la revendication 17, caractérisé en ce que le filtre d'échantillonnage (3) est constitué par au moins une cascade à un étage de filtres partiels (37, 38, 39), l'un au moins de ces filtres partiels pouvant être représenté par au moins une cascade à un étage de sous-filtres identiques qui ont tous des coefficients identiques et équivalents.

**Fig. 1**

**Fig. 2**

**Fig. 3**

Zur
Übersetzungsstufe 2

Eingangs-
Abtastfrequenz → Messung der Zeitdifferenz ← Ausgangs-
Abtastfrequenz

1

Umrechnung
der Abtastfrequenz

6

**Fig. 4**

Zur
Übersetzungsstufe 1

Zeitliche
Mittelung

7

Eingangs-
Abtastfrequenz → Messung der Zeitdifferenz ← Ausgangs-
Abtastfrequenz

1

**Fig. 5**

Eingangs-
Abtast-
folge → | 1. Teil-filter | 2. Teil-filter | n-tes Teil-filter | Unter-Abtastung | → Ausgangs-
Abtastfolge

31     32     33     8

3

Von
Übersetzungsstufe 2

2

Fig. 6

| Einschieben von Nullen | 1. Teil-filter | 2. Teil-filter | n-tes Teil-filter |

Eingangs-Abtast-folge → Ausgangs-Abtastfolge

35

9    34    36

3

Von
Übersetzungsstufe 2

Fig. 7

Eingangs-Abtastfolge → Ausgangs-Abtastfolge

3

2

Eingangs-Abtastfrequenz

Vergleich der Abtast-frequenzen

10

1    Ausgangs-Abtastfrequenz

Fig. 8

Fig. 9

Fig. 10

Eingangs-
Abtastfolge → | Vorfilter | → | | → | Nachfilter | → Ausgangs-
Abtastfolge

11        3        13

2

Eingangs-
Abtastfrequenz → | Frequenzverviel-
fachung | → | | → | Frequenz-
vervielfachung | → Ausgangs-
Abtastfrequenz

12        1        14

Eingangsabtastwerte    $f_c = 1/T$

Eingang

16 T

$T$

1)    Nullwertige
Abtastwerte    $i \cdot T$    $j \cdot T$    $t$

2)    Transversalfilter $(i \cdot T)$

Ausgang
$(i \cdot T)$

3)    Transversalfilter $(j \cdot T)$

Ausgang $(j \cdot T)$

Ausgang

$i \cdot T$  $j \cdot T$

4)    $t$

*Fig. 11*